(19) Europäisches Patentamt
European Patent Office
Office européen des brevets

(11) **EP 4 099 531 B1**

(12) **EUROPÄISCHE PATENTSCHRIFT**

(45) Veröffentlichungstag und Bekanntmachung des Hinweises auf die Patenterteilung:
**13.12.2023   Patentblatt 2023/50**

(21) Anmeldenummer: **22168172.9**

(22) Anmeldetag: **13.04.2022**

(51) Internationale Patentklassifikation (IPC):
*H02H 9/08* (2006.01)        *G01R 27/16* (2006.01)
*H02H 3/16* (2006.01)

(52) Gemeinsame Patentklassifikation (CPC):
**H02H 9/08; G01R 27/16;** H02H 3/165

(54) **VERFAHREN ZUR ERMITTLUNG VON NETZPARAMETERN ZUR REGELUNG EINER PETERSEN-SPULE**

METHOD FOR DETERMINING NETWORK PARAMETERS FOR CONTROLLING A PETERSEN COIL

PROCÉDÉ DE DÉTERMINATION DES PARAMÈTRES RÉSEAU DESTINÉ À LA COMMANDE D'UNE BOBINE DE PETERSEN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.06.2021   AT 504402021**

(43) Veröffentlichungstag der Anmeldung:
**07.12.2022   Patentblatt 2022/49**

(73) Patentinhaber: **Sprecher Automation GmbH 4020 Linz (AT)**

(72) Erfinder: **Druml, Gernot 4212 Neumarkt im Mühlkreis (AT)**

(74) Vertreter: **Hübscher & Partner Patentanwälte GmbH Spittelwiese 4 4020 Linz (AT)**

(56) Entgegenhaltungen:
**EP-A1- 3 657 620     DE-B3- 10 307 668 US-A- 5 559 439**

**Beschreibung**

Die Erfindung bezieht sich auf ein Verfahren zur Ermittlung von Netzparametern zur Regelung einer Petersen-Spule zur Erdschlusskompensation eines mehrphasigen Stromnetzes mit einer Nennfrequenz, wobei ein Nullspannungssignal erfasst wird.

In einem gelöschten oder isolierten Stromnetz fließen aufgrund der Leiter-Erdkapazitäten im Falle eines Erdschlusses hohe Ströme zwischen der Erde und dem erdschlussbehafteten Leiter. Ein Erdschluss führt somit nicht nur zu einer Störung des Stromnetzes, sondern auch zu einem hohen Gefährdungspotential am Ort des Erdschlusses. Aus dem Stand der Technik ist es daher bekannt, Petersen-Spulen einzusetzen, die den kapazitiven Erdschlussstrom kompensieren, indem sie einen Parallelschwingkreis bilden, der den Strom über die Erdschlussstelle minimiert. Dadurch wird die Gefahr eines Stromunfalls gesenkt und das erdschlussbehaftete Netz kann trotz des Erdschlusses weiterbetrieben werden. Um den Parallelschwingkreis der Petersen-Spule auf die Leitungskapazitäten anzupassen, muss allerdings die Eigenfrequenz des zu kompensierenden Schwingkreises bekannt sein.

Die Regelung der Petersen-Spule ist eine Präventivmaßnahme für den Fall des Erdschlusses und soll im gesunden Netzzustand durchgeführt werden. Die Zunahme der Vermaschung der Stromnetze und immer häufigeres Redispatchen machen ein häufiges Nachregeln erforderlich.

Zur Ermittlung der Eigenfrequenz schlägt die AT504506B1 vor, dass nach einem selbsttätig verlöschenden Erdschluss die Nullspannung während eines Zeitintervalles zu Beginn des Ausschwingvorganges erfasst und dabei aus der Zeit zwischen den Nulldurchgängen der Nullspannung eine Anzahl von Momentanfrequenzwerten ermittelt und aus dieser die Frequenz des Ausschwingvorgangs extrapoliert wird.

Nachteilig am Stand der Technik ist einerseits, dass eine Ermittlung der Abstimmung erst nach einem Erdschluss erfolgen kann und bei Auftreten einer natürlichen Unsymmetrie nicht mehr angewandt werden kann, da naturgemäß die zum Ausschwingvorgang gehörenden Nulldurchgänge nicht mehr bestimmt werden können.

Um die Eigenfrequenz dennoch ermitteln zu können, schlägt die WO2016029890A1 vor, beim erdschlussfreien Stromnetz ein Hilfssignal mit variabler Frequenz auf eine Nullsequenzkomponente aufzumodulieren und eine Frequenzanalyse für den entstehenden Schwingkreis durchzuführen. In weiterer Folge wird die Eigenfrequenz bestimmt, bei der der geringste Strom fließt. Diese Eigenfrequenz wird mit der Nennfrequenz des elektrischen Systems verglichen, um zu bestimmen, ob der Schwingkreis über- oder unterkompensiert ist, woraufhin die Induktivität der Petersen-Spule dementsprechend angepasst wird.

Nachteilig daran ist allerdings, dass dieses Verfahren zeitaufwändig ist, da die Einschwingzeit der jeweiligen Frequenz abgewartet werden muss. Es muss außerdem für jede Frequenzkomponente die Admittanz und Leitfähigkeit ermittelt werden, ob der Schwingkreis bei dieser Frequenz über- oder unterkompensiert ist, weswegen eine Vielzahl an möglichen Frequenzen evaluiert werden muss.

Weitere Verfahren zur Ermittlung von Netzparametern und zur Regelung einer Petersen-Spule sind aus DE 103 07 668, EP 3 657 620 und US 5 559 439 bekannt.

Der Erfindung liegt somit die Aufgabe zugrunde, ein Verfahren zur Ermittlung von Netzparametern zur Erdschlusskompensation bereitzustellen, bei dem selbst bei auftretender natürlicher Unsymmetrie die Netzparameter für eine Petersen-Spule zuverlässig innerhalb einer Periode der Netzfrequenz festgestellt werden können.

Die Erfindung, die vom Verfahrensanspruch 1 definiert wird, löst die gestellte Aufgabe dadurch, dass das kontinuierliche Nullspannungssignal bei einem transienten Ausschwingvorgang über eine Periode der Nennfrequenz abgetastet und je Zeitschritt als Nullspannungszeiger in den komplexen Bildbereich transformiert wird, wonach je Zeitschritt durch Verminderung der Winkelgeschwindigkeit des Nullspannungszeigers um eine Referenzwinkelgeschwindigkeit ein Synchronnullspannungszeiger gebildet und je Zeitschritt die vektorielle Differenz zwischen zwei Synchronnullspannungszeigern mit vorgegebenem Zeitabstand bestimmt wird, wonach die Winkelabweichung zwischen den vektoriellen Differenzen zweier Zeitschritte als Winkelgeschwindigkeitsabweichung des Nullspannungszeigers von der Referenzwinkelgeschwindigkeit und/oder die Betragsabweichung der vektoriellen Differenzen zweier Zeitschritte als Dämpfung des Nullspannungszeigers ausgegeben wird. Ein transienter Ausschwingvorgang kann beispielsweise durch einen erstmaligen oder wiederzündenden Erdschluss einer Phase hervorgerufen werden, oder über eine Einspeisung eines Modulationsstroms erfolgen. Die Abtastung des Nullspannungssignals erfolgt vorzugsweise mit einem ganzzahligen Vielfachen der Nennfrequenz des Stromnetzes und kann beispielsweise über einen Analog-Digital-Wandler erfolgen, der die Abtastwerte an eine Recheneinheit weiterleitet. Diese Recheneinheit transformiert das Nullspannungssignal anhand der Abtastwerte in den komplexen Bildbereich. Die dabei je Zeitschritt gebildeten Zeiger werden als Nullspannungszeiger bezeichnet. Daraufhin wird die Winkelgeschwindigkeit der Nullspannungszeiger um eine Referenzwinkelgeschwindigkeit unter Ausbildung von Synchronnullspannungszeigern vermindert. Diese Referenzwinkelgeschwindigkeit kann beispielsweise die zur Nennfrequenz korrespondierende Winkelgeschwindigkeit sein. In einer bevorzugten Ausführungsform der Erfindung wird das verkettete Spannungssignal zwischen zwei Leitern abgetastet, ebenso transformiert und dessen Winkelgeschwindigkeit als Referenzwinkelgeschwindigkeit herangezogen. Darüber hinaus erleichtert die so reduzierte Winkelgeschwindigkeit des Synchronnullspannungszeigers die folgende Ermittlung der Netzparameter aus der Änderungsrate von Betrag und Winkel der vektoriellen Differenz zwischen zwei Synchronnullspannungszeigern mit vorgegebenem Zeitabstand. Dieser Zeitabstand kann fest vorgegeben sein. Da sich aber die Frequenz und folglich die Winkelgeschwindigkeit der Nullspannung von der Nennfrequenz unterscheiden kann, kann es bei der Transformation in den komplexen Bildbereich zu Leck-Effekten kommen, die sich in lokalen Minima und Maxima des Betrags des Nullspannungszeigers und in weiterer Folge im Betrag und Winkel des Synchronnullspannungszeigers manifestieren. Diese sich aus der Transformation in den komplexen Bildbereich ergebenden Störungen können entweder mittels eines zu bestimmenden Korrekturfaktors ausgeglichen werden, oder der Zeitabstand zwischen zwei Synchronnullspannungszeigern, die für die Bestimmung der vektoriellen Differenz herangezogen werden, wird so gewählt, dass die herangezogenen Synchronnullspannungszeiger mit lokalen Minima oder Maxima des Betrags des Synchronnullspannungszeigers zusammenfallen. In letzterem Fall entspricht der Zeitabstand also dem zeitlichen Abstand zwischen zwei Minima oder Maxima des Betrags des Synchronnullspannungszeigers. Durch die Bildung der vektoriellen Differenz zwischen zwei Synchronnullspannungszeigern, die einen vorgegebenen zeitlichen Abstand zueinander haben, kann ein sich durch eine natürliche Unsymmetrie ergebender Signalanteil entfernt werden, weil die natürliche Unsymmetrie die beiden Synchronnullspannungszeiger gleichermaßen beeinflusst. Der Nullspannungszeiger setzt sich nämlich aus zwei Komponenten zusammen, wovon eine ($\underline{U}_N$) mit der Nennfrequenz schwingt und eine ($\underline{U}_{ab}$) den abklingenden Spannungsanteil des Ausschwingvorgangs repräsentiert. Diese beiden Komponenten können durch folgende Gleichungen beschrieben werden

$$\underline{U}_N = U_N e^{j\omega_N t}$$

$$\underline{U}_{ab} = U_{ab} e^{-\lambda t + j(\omega_{ab}t + \varphi_0)}$$

Der Nullspannungszeiger $\underline{U}_0$ ist daher folglich $\underline{U}_N + \underline{U}_{ab}$, also

$$\underline{U}_0 = U_N e^{j\omega_N t} + U_{ab} e^{-\lambda t + j(\omega_{ab}t + \varphi_0)}$$

Mathematisch kann nun der Synchronnullspannungszeiger $\underline{U}_{0S}$ folgendermaßen gebildet werden

$$\underline{U}_{0S} = \underline{U}_0 e^{-j\omega_N t} = U_N + U_{ab} e^{-\lambda t + j(\omega_{ab}t + \varphi_0) - j\omega_N t}$$

oder vereinfacht

$$\underline{U}_{0S} = U_N + U_{ab} e^{-\lambda t + j(\Delta\omega t + \varphi_0)}$$

Dabei sind $U_N$ und $U_{ab}$ die Amplituden des Nennspannungsanteils bzw. der abklingenden Spannung, $\omega_N$ und $\omega_{ab}$ die Winkelgeschwindigkeit des Nennspannungsanteils bzw. des abklingenden Anteils, *t* die Zeit und *j* die imaginäre Einheit. $\lambda$ ist die (reale) Zeitkonstante des Abklingvorgangs, $\Delta\omega$ ist die Differenz zwischen $\omega_{ab}$ und $\omega_N$ und $\varphi_0$ die Phasenverschiebung. Durch die Bildung der vektoriellen Differenz fällt der zeitlich konstante Teil $U_N$ weg, wodurch die natürliche Unsymmetrie die Ermittlung der Winkelgeschwindigkeitsabweichung und der Dämpfung als Netzparameter nicht behindert. Der Erfindung liegt die Erkenntnis zu Grunde, dass die Synchronnullspannungszeiger im Falle eines transienten Ausschwingvorgangs in der komplexen Bildebene eine logarithmische Spirale bilden, sodass die Winkelgeschwindigkeit der Synchronnullspannungszeiger genauso wie die logarithmische Dämpfung des Betrags der Synchronnullspannungszeiger während des Ausschwingvorgangs weitgehend konstant sind. Somit sind auch die Winkelgeschwindigkeit der vektoriellen Differenz zwischen zwei Synchronnullspannungszeigern und die Änderungsrate der Dämpfung der vektoriellen Differenz zwischen zwei Synchronnullspannungszeigern während des Ausschwingvorgangs weitgehend konstant und erlauben einen Rückschluss auf die Änderungsraten der Winkelgeschwindigkeit und des Betrags des Synchronnullspannungszeigers und damit auch des Nullspannungszeigers selbst. Aufgrund der konstanten Winkelgeschwindigkeit und der konstanten Änderungsrate der Dämpfung während des Ausschwingvorgangs können die Netzparameter zur Regelung der Petersen-Spule innerhalb einer Netzperiode insbesondere innerhalb einer halben Netzperiode nach einem Vielfachen der vorgegebenen Zeitabstände durch Mittelung zuverlässig bestimmt werden, vorausgesetzt, dass die maßgeblichen Störeinflüsse auf die Transformation in den komplexen Bildbereich abgeklungen sind. Bei der Transformation in den komplexen Bildbereich kann es sich beispielsweise um eine diskrete Fourier-Transformation handeln. Als zusätzlicher Vorteil ergibt sich, dass zu Beginn des Ausschwingvorgangs die Signalamplituden verhältnismäßig groß sind, sodass das daraus resultierende hohe Signal-zu-Rausch-Verhältnis die zuverlässige Bestimmung der Netzparameter begünstigt. Die Recheneinheit kann die Abweichung des Winkels der vektoriellen Differenz zweier Zeitschritte als Winkelgeschwindigkeitsabweichung des Nullspannungszeigers von der Referenzwinkelgeschwindigkeit und/oder die Betragsabweichung der vektoriellen Differenzen zweier Zeitschritte als Dämpfung des Nullspannungszeigers als Netzparameter an einen Regler für die Petersen-Spule übergeben, um den Parallelschwingkreis so zu stimmen, dass ein kapazitiver Erdschlussstrom kompensiert werden kann.

Der Ressourcenaufwand zur Durchführung des erfindungsgemäßen Verfahrens auf einer Recheneinheit kann reduziert werden, wenn wie oben beschrieben, der vorgegebene Zeitabstand der zeitliche Abstand zwischen zwei Minima oder Maxima des Betrags des Synchronnullspannungszeigers ist. Zufolge dieser Maßnahmen kann der Einfluss einer Frequenzabweichung bei der Transformation in den komplexen Bildbereich in einfacher Weise ausgeglichen werden, ohne dass Korrekturfaktoren bestimmen werden müssen.

Um die Netzparameter zur Regelung einer Petersen-Spule bereits im gesunden Betrieb vor Eintreten eines Erdschlusses zu bestimmen, empfiehlt es sich, dass das Nullsystem mit einem Modulationsstromimpuls beaufschlagt wird, wonach im Abklingvorgang das Nullspannungssignal zur Bestimmung des Nullspannungszeigers abgetastet wird. Zur Beaufschlagung mit einem Modulationsstromimpuls kann beispielsweise eine zusätzliche Impedanz für einen vorgegebenen Zeitraum zwischen Sternpunkt des Stromnetzes und Erde geschaltet werden. Dieser Zeitraum kann wenigstens eine halbe Periode der Nennfrequenz betragen. Im Falle eines symmetrischen Netzes mit geringer oder keiner Nullspannung kann der Sternpunkt über die zusätzliche Impedanz alternativ mit einer Spannungsquelle verbunden werden. Der Modulationsstromimpuls kann dabei unterschiedliche Signalformen aufweisen, wie beispielsweise die eines angenäherten Dirac-Pulses, eines Wechselsignals mit Nennfrequenz oder eines Wechselsignals mit mehreren und/oder variierenden Frequenzanteilen. Die Einspeisung des Modulationsstromimpulses in das Nullsystem kann beispielsweise am Sternpunkt des mehrphasigen Stromnetzes erfolgen, wobei eine Einspeisung sowohl vor der Petersen-Spule, als auch zwischen Petersen-Spule und Sternpunkt möglich ist.

Gerade bei großen Stromnetzen kann die für die Einspeisung des Modulationsstromimpulses erforderliche Energie beträchtlich sein, sodass es sich gerade bei Stromnetzen mit natürlicher Unsymmetrie empfiehlt, zur Beaufschlagung des Nullsystems mit einem Modulationsstromimpuls den Sternpunkt über eine strombegrenzende Impedanz gegen Erde kurzzuschließen.

Das erfindungsgemäße Verfahren hat somit den Vorteil, dass auch externe Petersen-Spulen berücksichtigt werden können, da diese die Nullspannung im Ausschwingvorgang mitbeeinflussen und somit deren Zu- und Abschalten erkannt werden kann.

In der Zeichnung ist der Erfindungsgegenstand beispielsweise dargestellt. Es zeigen

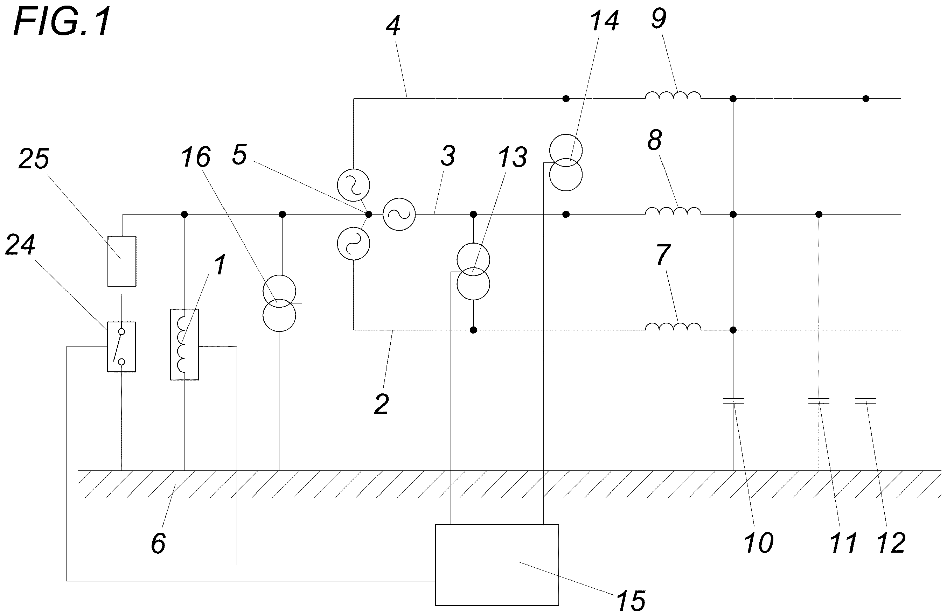

Fig. 1    ein schematisches Blockschaltbild eines dreiphasigen Stromnetzes mit einer Petersen-Spule,
Fig. 2a    den zeitlichen Spannungs- und Stromverlauf des Nullspannungssignals während eines transienten Ausschwingvorgangs ohne natürlicher Unsymmetrie,
Fig. 2b    einen der Fig. 2a entsprechenden Synchronnullspannungszeiger in der komplexen Ebene,
Fig. 3a    den zeitlichen Verlauf des absoluten Betrags des Synchronnullspannungszeigers der Fig. 2b,
Fig. 3b    der zeitliche Verlauf des Winkels des Synchronspannungszeigers der Fig 2b,
Fig. 4a    den zeitlichen Spannungs- und Stromverlauf des Nullspannungssignals während eines transienten Ausschwingvorgangs mit natürlicher Unsymmetrie,
Fig. 4b    einen der Fig. 4a entsprechenden Synchronnullspannungszeiger in der komplexen Ebene,
Fig. 5a    den zeitlichen Spannungs- und Stromverlauf des Nullspannungssignals bei Beaufschlagung mit einem Modulationsstromimpuls mit natürlicher Unsymmetrie und
Fig. 5b    einen der Fig. 5a entsprechenden Synchronnullspannungszeiger in der komplexen Ebene.

Bei einem erfindungsgemäßen Verfahren werden die Parameter für eine Petersen-Spule 1 für ein Stromnetz mit drei Leitern 2, 3, 4 ermittelt. Die Petersen-Spule 1 ist dabei zwischen dem Sternpunkt 5 der Sternschaltung der drei Leiter 2, 3, 4 und der Erde 6 geschaltet, um einen Parallelschwingkreis aus der Petersen-Spule 1 und den Induktivitäten 7, 8, 9 und den Erdkapazitäten 10, 11, 12 der Leiter 2, 3, 4 zu bilden. Auf die Darstellung der ohm'schen Leitungswiderstände wurde aus Übersichtlichkeitsgründen verzichtet. Spannungswandler 13, 14 erlauben die Bestimmung der verketteten Spannung zwischen den einzelnen Phasen 2, 3, 4 und können die verkettete Spannung über eine Periode der Nennfrequenz abtasten und diese Abtastwerte an eine Recheneinheit 15 leiten. Darüber hinaus ist ein Spannungswandler 16 vorgesehen, der die Nullspannung zwischen dem Sternpunkt 5 und der Erde 6 erfasst, abtastet und das abgetastete Nullspannungssignal 17 an die Recheneinheit 15 leitet.

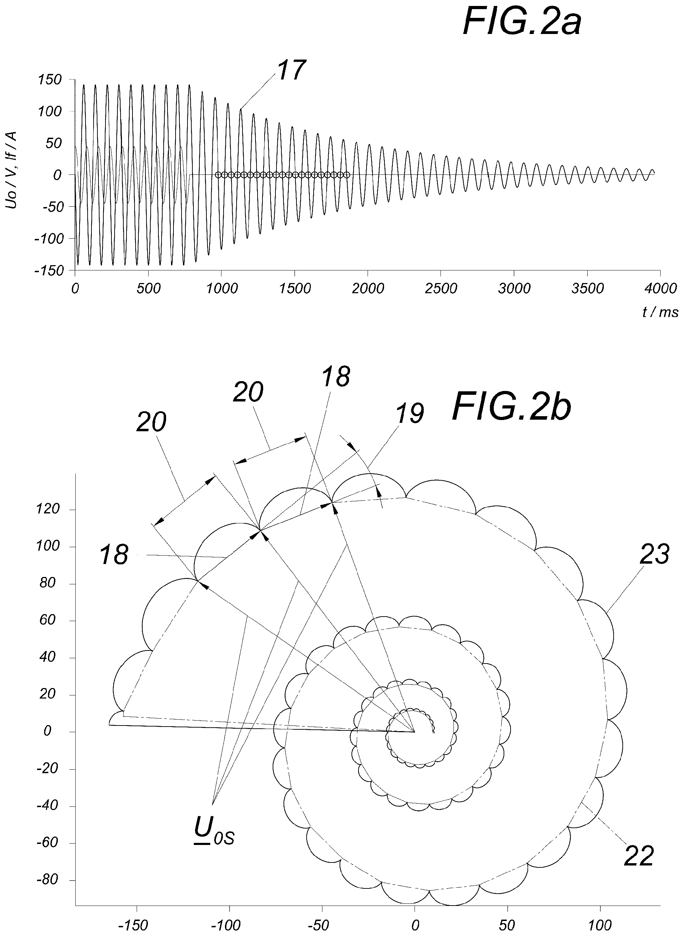

Während eines transienten Ausschwingvorganges wird das beispielsweise für einen Fall ohne natürliche Unsymmetrie in der Fig. 2a dargestellte Nullspannungssignal 17 über eine Periode der Nennfrequenz des Stromnetzes abgetastet und von der Recheneinheit 15 als Nullspannungszeiger $U_0$ im Ausschwingvorgang in den komplexen Bildbereich transformiert. Die Winkelgeschwindigkeit dieses Nullspannungszeigers $U_0$ wird anschließend um eine Refe-

renzwinkelgeschwindigkeit $\omega_N$ vermindert und dadurch der Synchronnullspannungszeiger $\underline{U}_{0S}$ gebildet. Diese Referenzwinkelgeschwindigkeit $\omega_N$ kann entweder aus der Nennfrequenz oder aber aus der Frequenz des verketteten Spannungssignals zwischen zwei Phasen 2, 3, 4 abgeleitet werden.

In einer bevorzugten Ausführungsform wird je Zeitschritt das Nullspannungssignal 17 abgetastet, als Nullspannungszeiger $\underline{U}_0$ in den komplexen Bildbereich transformiert und daraus ein Synchronnullspannungszeiger $\underline{U}_{0S}$ gebildet. Für jeden Zeitschritt wird sodann die vektorielle Differenz 18 zwischen dem Synchronnullspannungszeiger $\underline{U}_{0S}$ dieses Zeitschritts und eines Synchronnullspannungszeigers $\underline{U}_{0S}$ eines vorangegangenen Zeitschritts, vorzugsweise des unmittelbar vorangegangenen Zeitschrittes gebildet. Zu diesem Zweck kann die Recheneinheit 15 wenigstens einen Synchronnullspannungszeiger $\underline{U}_{0S}$ eines vorangegangenen Zeitschritts zwischenspeichern.

Sodann kann die Winkelabweichung 19 zwischen den vektoriellen Differenzen 18 zweier Zeitschritte bestimmt und als Winkelgeschwindigkeitsabweichung $\Delta\omega$ des Nullspannungszeigers $\underline{U}_0$ von der Referenzwinkelgeschwindigkeit $\omega_N$ ausgegeben werden.

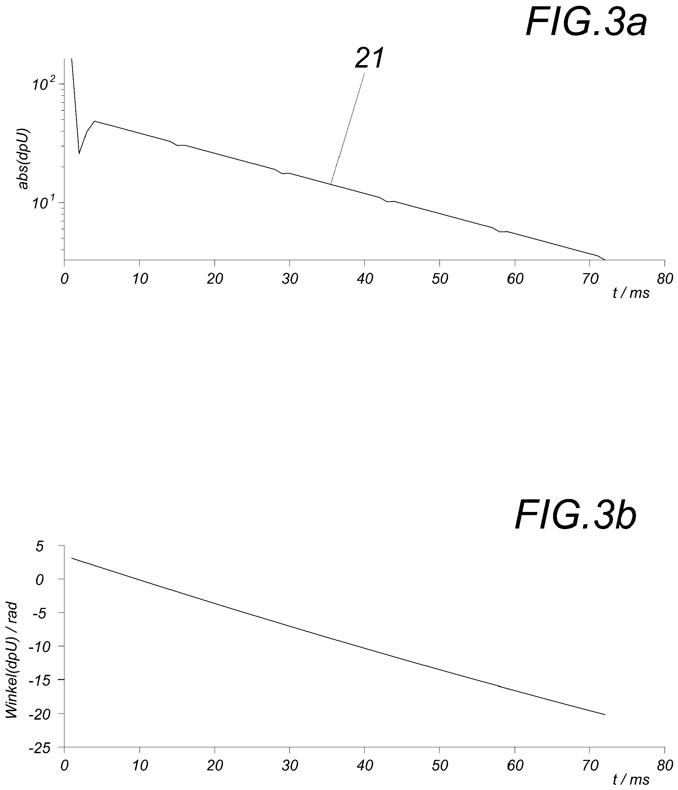

Ebenfalls kann die Betragsabweichung zwischen den Beträgen 20 der vektoriellen Differenzen 18 zweier Zeitschritte bestimmt und als Dämpfung des Nullspannungszeigers $\underline{U}_0$ und somit auch des Synchronspannungszeigers $\underline{U}_{0S}$ ausgegeben werden. Der zeitliche Verlauf des Logarithmus des Betrags 21 ist für den in der Fig. 2b dargestellten Fall in der Fig. 3a abgebildet, wobei die Steigung dieser Kurve der Dämpfung entspricht.

In einer bevorzugten Ausführungsform wird für jeden Zeitschritt eine Winkelabweichung 19 und eine Betragsabweichung zwischen den Beträgen 20 bestimmt, wobei jeweils vektorielle Differenzen 18 zweier unmittelbar aufeinanderfolgender Zeitschritte für die Berechnung herangezogen werden. Somit müssen in der Recheneinheit 15 jeweils nur ein Synchronnullspannungszeiger $\underline{U}_{0S}$ des vorangegangenen Zeitschritts sowie eine vektorielle Differenz 18 des vorangegangenen Zeitschritts zwischengespeichert werden, was einen äußerst geringen Ressourcenverbrauch ermöglicht.

Bei wiederholter Anwendung des erfindungsgemäßen Verfahrens bilden die vektoriellen Differenzen 18 näherungsweise eine logarithmische Spirale 22, wobei der zeitliche Verlauf der einzelnen Synchronnullspannungszeiger $\underline{U}_{0S}$ durch eine Verbindungslinie 23 angedeutet wird.

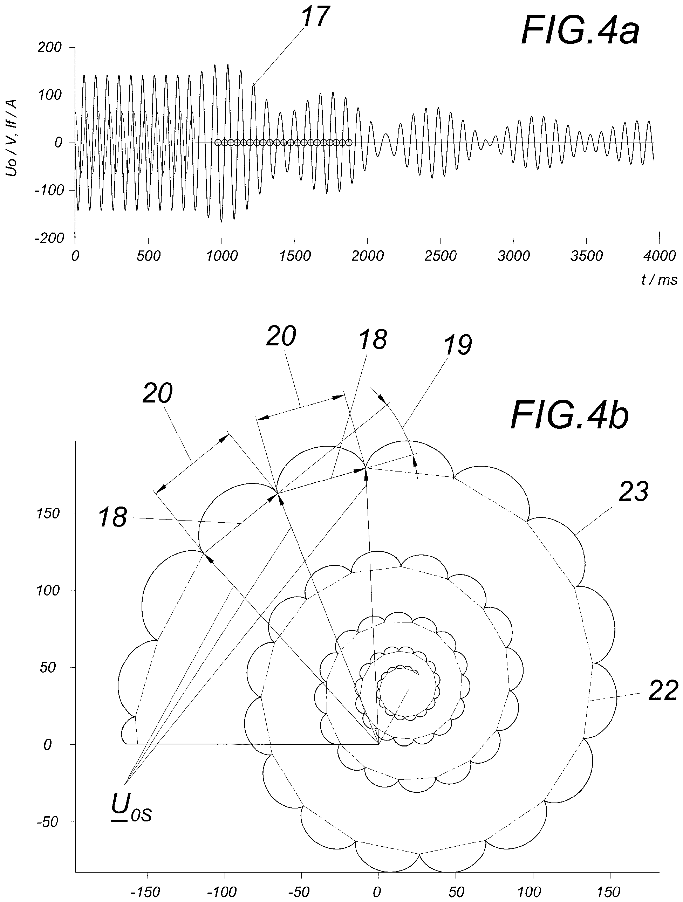

Der Winkel dieser Synchronnullspannungszeiger $\underline{U}_{0S}$ ist für den in der Fig. 2b dargestellten Fall im zeitlichen Verlauf in der Fig. 3b dargestellt. Die Steigung dieser Kurve entspricht der Winkelgeschwindigkeitsabweichung und ist $\Delta\omega$. Während sich die Figs. 2a bis 3b auf den Fall ohne natürliche Unsymmetrie beziehen, zeigen die Figs. 4a und 4b einen beispielsweisen Fall mit natürlicher Unsymmetrie. Wie insbesondere der Fig. 4b entnommen werden kann, ist dabei die logarithmische Spirale 22 aus dem Nullpunkt heraus verschoben. Durch die erfindungsgemäßen Maßnahmen ändert dies aber nichts an der Bestimmung der Netzparameter. Durch die Bildung der vektoriellen Differenzen 18 wird nämlich der unsymmetrische Signalanteil eliminiert.

Um für die Bestimmung der Netzparameter nicht erst einen Störfall abwarten zu müssen, der einen transienten Ausschwingvorgang der Nullspannung zufolge hat, wird erfindungsgemäß vorgeschlagen, dass das Nullsystem mit einem Modulationsstromimpuls beaufschlagt wird, wonach im Abklingvorgang das Nullspannungssignal zur Bestimmung des Nullspannungszeigers $\underline{U}_0$ abgetastet und das erfindungsgemäße Verfahren wie oben beschrieben weiter durchgeführt wird.

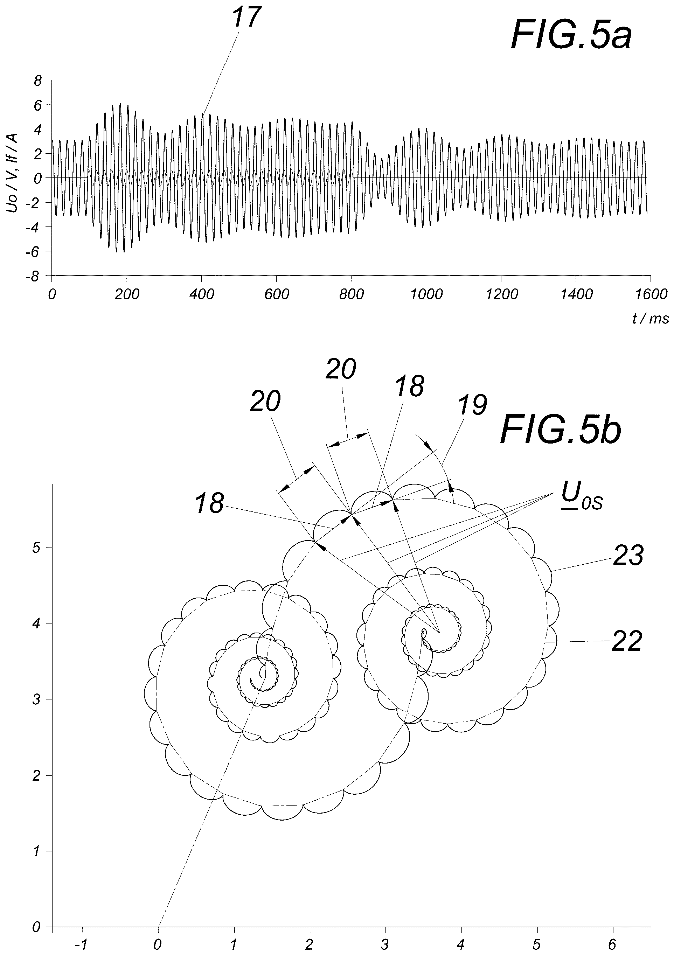

Zur Einspeisung des Modulationsstromimpulses können unterschiedliche Maßnahmen gesetzt werden. Besonders einfache Bedingungen ergeben sich aber, wenn der Sternpunkt 5 über einen Leistungsschalter 24 durch die Recheneinheit 15 gegen Erde 6 kurzfristig über eine strombegrenzende Impedanz 25 kurzgeschlossen werden kann. Durch einen solchen Modulationsstromimpuls wird das Nullsystem angeregt und es stellt sich nach dem Ende des Modulationsstromimpulses ein Abklingvorgang ein, der zur Durchführung des erfindungsgemäßen Verfahrens erforderlich ist. Die Nullspannung und ein den Figs. 2b und 4b entsprechendes komplexes Zeigerdiagramm ist für diesen Fall in den Figs. 5a und 5b abgebildet.

## Patentansprüche

1. Verfahren zur Ermittlung von Netzparametern zur Regelung einer Petersen-Spule (1) zur Erdschlusskompensation eines mehrphasigen Stromnetzes mit einer Nennfrequenz, wobei ein Nullspannungssignal (17) erfasst wird, wobei das kontinuierliche Nullspannungssignal (17) bei einem transienten Ausschwingvorgang über eine Periode der Nennfrequenz abgetastet und je Zeitschritt als Nullspannungszeiger $\underline{U}_0$ in den komplexen Bildbereich transformiert wird, **dadurch gekennzeichnet, dass**
je Zeitschritt durch Verminderung der Winkelgeschwindigkeit des Nullspannungszeigers $\underline{U}_0$ um eine Referenzwinkelgeschwindigkeit $\omega_N$ ein Synchronnullspannungszeiger $\underline{U}_{0S}$ gebildet und je Zeitschritt die vektorielle Differenz (18) zwischen zwei Synchronnullspannungszeigern $\underline{U}_{0S}$ mit vorgegebenem Zeitabstand bestimmt wird, wonach die Winkelabweichung (19) zwischen den vektoriellen Differenzen (18) zweier Zeitschritte als Winkelgeschwindigkeitsabweichung des Nullspannungszeigers $\underline{U}_0$ von der Referenzwinkelgeschwindigkeit $\omega_N$ und/oder die Betragsabweichung der vektoriellen Differenzen (18) zweier Zeitschritte als Dämpfung des Nullspannungszeigers $\underline{U}_0$ ausgegeben

**EP 4 099 531 B1**

wird.

2. Verfahren nach Anspruch 1, **dadurch gekennzeichnet, dass** der vorgegebene Zeitabstand der zeitliche Abstand zwischen zwei Minima oder Maxima des Betrags des Synchronnullspannungszeigers $\underline{U}_{0S}$ ist.

3. Verfahren nach Anspruch 1 oder 2, **dadurch gekennzeichnet, dass** das Nullsystem mit einem Modulationsstromimpuls beaufschlagt wird, wonach im Abklingvorgang das Nullspannungssignal (17) zur Bestimmung des Nullspannungszeigers $\underline{U}_0$ abgetastet wird.

4. Verfahren nach Anspruch 3, **dadurch gekennzeichnet, dass** zur Beaufschlagung des Nullsystems mit einem Modulationsstromimpuls der Sternpunkt (5) gegen Erde (6) über eine strombegrenzende Impedanz (25) kurzgeschlossen wird.

**Claims**

1. Method for determining power grid parameters for controlling a Petersen coil (1) for earth fault compensation of a polyphase power grid with a nominal frequency, wherein a zero-sequence voltage signal (17) is detected, wherein the continuous zero-sequence voltage (17) is sampled during a transient decay process over a period of the nominal frequency and is transformed per time step as zero-sequence voltage pointer $\underline{U}_0$ into the complex image area, **characterized in that** for each time step, by reducing the angular velocity of the zero-sequence voltage pointer $\underline{U}_0$ by a reference angular velocity $\omega_N$ a synchronous zero-sequence voltage pointer $\underline{U}_{0S}$ is formed per time step by reducing the angular velocity of the zero-sequence voltage pointer by a reference angular velocity, and the vectorial difference (18) between two synchronous zero-sequence voltage pointers $\underline{U}_{0S}$ is determined with a predetermined time interval, whereafter the angular deviation (19) between the vectorial differences (18) of two time steps is determined as angular velocity deviation of the zero-sequence voltage pointer $\underline{U}_0$from the reference angular velocity $\omega_N$ and/or the amount deviation of the vectorial differences (18) of two time steps as damping of the zero-sequence voltage pointer $\underline{U}_0$ is output.

2. The method according to claim 1, **characterized in that** the predetermined time interval is the time interval between two minima or maxima of the magnitude of the synchronous zero-sequence voltage pointer $\underline{U}_{0S}$.

3. Method according to claim 1 or 2, **characterized in that** a modulation current pulse is applied to the zero-sequence system, whereafter, in the decay process, the zero-sequence voltage signal (17) is sampled to determine the zero-sequence voltage vector $\underline{U}_0$.

4. The method according to claim 3, **characterized in that** for applying a modulation current pulse to the zero-sequence system, the neutral point (5) is short-circuited to ground (6) via a current-limiting impedance (25).

**Revendications**

1. Procédé de détermination de paramètres de réseau pour le réglage d'une bobine de Petersen (1) pour compenser les défauts de terre d'un réseau électrique polyphasé doté d'une fréquence nominale, selon lequel un signal de tension nulle(17) est enregistré, ce signal de tension nulle continu (17) étant échantillonné lors d'un processus de relâchement transitoire sur une période de la fréquence nominale et chaque intervalle de temps étant transformé en vecteur de tension nulle $\underline{U}_o$ dans la zone d'image complexe, **caractérisé en ce qu'**à chaque incrément de temps, un vecteur de tension nulle synchrone $\underline{U}_{os}$ est formé en réduisant la vitesse angulaire du vecteur de tension nulle $\underline{U}_o$ d'une vitesse angulaire de référence $\omega_N$ et à chaque incrément de temps, la différence vectorielle (18) entre deux vecteurs de tension nulle synchrone $\underline{U}_{os}$ est déterminée avec un écart temporel prédéfini, après quoi l'écart angulaire (19) entre les différences vectorielles (18) des deux incréments de temps est déduite comme étant l'écart de vitesse angulaire du vecteur de tension nulle $\underline{U}_o$ par rapport à la vitesse angulaire de référence $\omega_N$ et/ou l'écart quantitatif des différences vectorielles (18) des deux incréments de temps comme étant l'amortissement du vecteur de tension nulle $\underline{U}_o$.

2. Procédé selon la revendication 1, **caractérisé en ce que** l'écart temporel prédéfini est l'écart temporel entre deux minima ou maxima de la quantité du vecteur de tension nulle synchrone $\underline{U}_{os}$.

3. Procédé selon la revendication 1 ou 2, **caractérisé en ce que** le système homopolaire est soumis à une impulsion de courant de modulation, après quoi le signal de tension nulle (17) est échantillonné pendant le processus d'affaiblissement pour déterminer le vecteur de tension nulle $\underline{U}_o$.

4. Procédé selon la revendication 3, **caractérisé en ce que**, pour soumettre le système homopolaire à une impulsion de courant de modulation, le point neutre (5) est mis en court-circuit avec la terre (6) par le biais d'une impédance limitant le courant (25).

FIG.1

EP 4 099 531 B1

# FIG.2a

# FIG.2b

## FIG.3a

## FIG.3b

FIG.4a

FIG.4b

*17*

*FIG.5a*

*20*

*20* *18*

*18* *19* *FIG.5b*

$\underline{U}_{OS}$

*23*

*22*

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- AT 504506 B1
- WO 2016029890 A1
- DE 10307668
- EP 3657620 A
- US 5559439 A